(19) Europäisches Patentamt

European Patent Office

Office européen des brevets

(11) **EP 1 033 811 A2**

(12) **EUROPEAN PATENT APPLICATION**

(43) Date of publication:
**06.09.2000 Bulletin 2000/36**

(51) Int. Cl.$^7$: **H03H 11/12**

(21) Application number: **00104403.1**

(22) Date of filing: **02.03.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **02.03.1999 US 261043**

(71) Applicant: **TRW Inc.**
**Redondo Beach, California 90278 (US)**

(72) Inventors:
• **Tang, Benjamin**
**Hawthorne, CA 90250 (US)**
• **Oshiro, Keith**
**Kapolei, HI 96707 (US)**
• **Uehara, Gregory T.**
**Honolulu, HI 96822 (US)**

(74) Representative:
**Schmidt, Steffen J., Dipl.-Ing.**
**Wuesthoff & Wuesthoff,**
**Patent- und Rechtsanwälte,**
**Schweigerstrasse 2**
**81541 München (DE)**

(54) **Monolithic fixed active equalizer**

(57) A cable equalizer (20) formed as an active filter that is amenable to being fabricated from heterojunction bipolar transistor (HBT) technology and thus, can be rather easily fabricated as a monolithic integrated circuit, consuming only nominal amounts of power and chip area. The active filter includes a pair of differentially connected transistors, such as HBT transistors (Q1A, Q1B), configured with a degeneration resistor (2R) and a shunt capacitance ($C_D/2$). The active filter (20) is able to provide a high frequency boost with linear phase performance.

**EP 1 033 811 A2**

**Description**

BACKGROUND OF THE INVENTION

1. Field of the Invention

The present invention relates to an equalizer and more particularly, to a monolithic active equalizer which allows for increased data rates and longer cable lengths in coaxial cable based data transmission systems that is amenable to being monolithically fabricated using heterojunction bipolar transistor (HBT) technology.

2. Description of the Prior Art

There is an ever increasing number of data communication applications in the GHz range, particularly in light of the evolving gigabit ethernet standard, which relate to short distance local area network (LAN) as well as long distance trunk applications. Optical data transmission systems are known to be used in the long distance applications. However, such optical data communication systems are relatively complex making such systems relatively unattractive for relatively short connections, such as in LAN applications. Copper-wire transmission links are relatively simple and much less expensive than optical systems making such copper-based links preferable to optical links in relatively short distance applications. Unfortunately, such copper-wire communication links are known to have relatively high attenuation and limited bandwidth which causes pulse spreading or intersymbol interference. More particularly, the attenuation of a wired communication link is known to be directly related to the length of the wire and the data rate, which severely limits the application of such wire communication links.
Equalizers are known which compensate for the attenuation effects of a wire communications link. Such equalizers are used to increase the data rate by conditioning the received signals and are known to allow higher data rates and long cable lengths. In the gigahertz range, equalizers have typically been implemented as RLC filters. The size and performance of on-chip spiral inductors used in such RLC filters makes monolithic fabrication of such equalizers difficult, if not impossible. Thus, there is a need for a cable equalizer for use in a data transmission system which provides increased data rates and longer cable distances.

**SUMMARY OF THE INVENTION**

The present invention relates to a cable equalizer formed as an active filter. The active filter is amenable to being fabricated from heterojunction bipolar transistor (HBT) technology and thus, can be rather easily fabricated as a monolithic integrated circuit, consuming only nominal amounts of power and chip area. The active filter includes a pair of differentially connected transistors, such as HBT transistors, configured with a degeneration resistor and a shunt capacitance. The active filter is able to provide a high frequency boost with linear phase performance.

DESCRIPTION OF THE DRAWINGS

These and other advantages of the present invention will be readily understood with reference to the following specification and attached drawing wherein:

FIG. 1 is a schematic diagram of an active cable equalizer in accordance with the present invention.
FIG. 2 is a block diagram of a receiver which incorporates the equalizer in accordance with the present invention.
FIG. 3 is a schematic diagram of the receiver illustrated in FIG. 2, implemented with an exemplary two stage equalizer.
FIGs. 4a and 4b are frequency response curves illustrating the S parameter S21 transmission response and group delay of an exemplary 30 foot of RG-316 coaxial cable.
FIG. 5 is the time domain response of the exemplary 30 foot of RG-316 coaxially cable.
FIG. 6 is a plan view of a chip die illustrating the total area of a receiver which incorporates the equalizer in accordance with the present invention.
FIG. 7a-7d represent eye diagrams illustrating the frequency response of an exemplary 5Gbps and 10Gbps received signal and the same signal after equalization.
FIGS. 8a-8h, 9a-9f and 10a-10c represent process diagrams for fabricating a device in accordance with one embodiment of the present invention utilizing GaAs heterojunction bipolar transistor technology.

## DETAILED DESCRIPTION

The present invention relates to a cable equalizer for compensating for attenuation of a coaxial cable in a data transmission system which allows for increased cable length and higher data rates relative to known cable equalizers. The cable equalizer is formed as an active lead lag filter from bipolar technology, such as heterojunction bipolar transistor (HBT) technology, which enables it to be fabricated monolithically as well as integrated with other components to form a monolithic receiver, as will be discussed in more detail below. The cable equalizer in accordance with the present invention is simplistic relative to other known equalizers and is adapted to operate at relatively high frequencies, up to, for example, 10GHz, while only consuming nominal amounts of power and chip area relative to known cable equalizers.

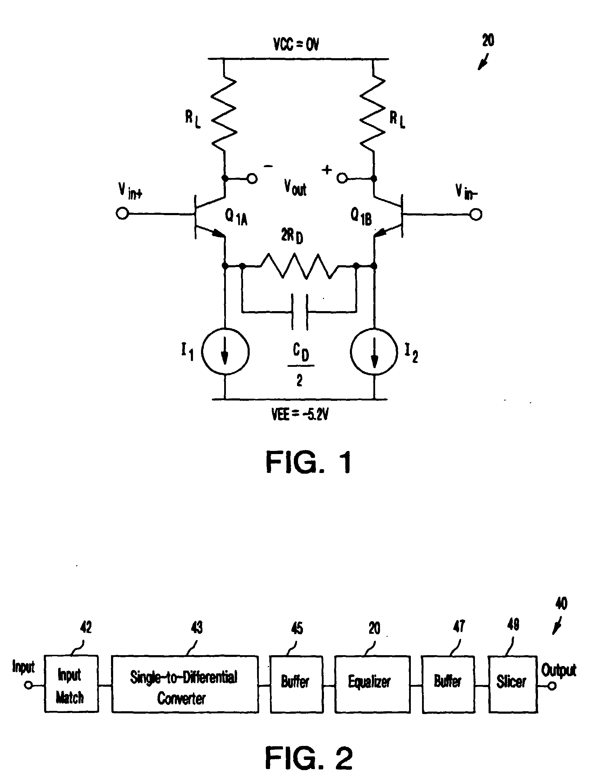

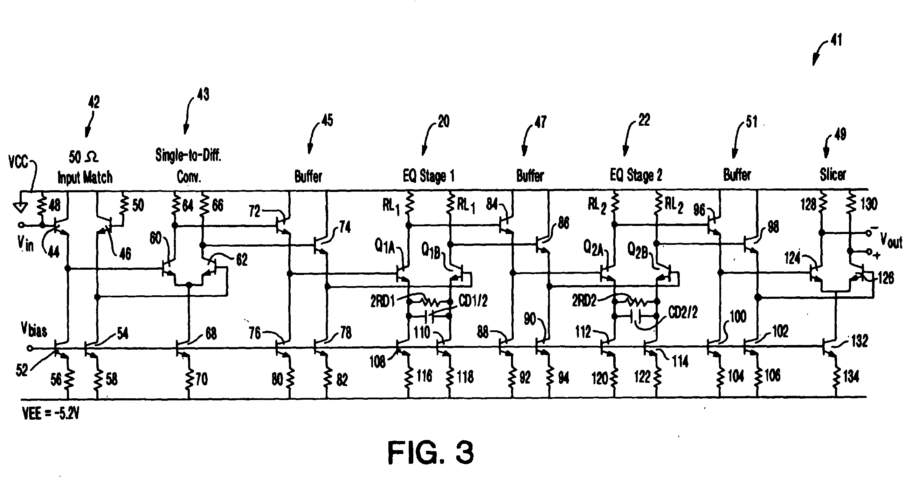

The equalizer architecture in accordance with the present invention is illustrated in FIG. 1 and generally identified with the reference numeral 20. The equalizer 20 is adapted to be integrated into a receiver, for example, the receiver 40, 41 illustrated in FIGS. 2 and 3, to provide relatively error free data transmission rates up to 10 Gbps over a RG-316 coaxial cable with lengths up to 30 feet. An important aspect of the invention is that the equalizer 20, as well as the receivers 40, 41, are adapted to be monolithically formed, for example from GaAs heterojunction bipolar transistor (HBT) technology, which has inherently higher bandwidth relative to silicon-based technologies and thus, allows for relatively higher data transmission rates. It should be understood, however, that the principles of the present invention are also applicable to silicon based bipolar junction transistor (BJT) based applications.

Referring to FIG. 1, the equalizer 20 includes a pair of differentially connected transistors Q1A and Q1B. The differentially connected transistors Q1A and Q1B are connected in a common emitter configuration. The base terminals of each of the transistors Q1A and Q1B form bipolar input terminals $V_{in+}$ and $V_{in-}$. An emitter degeneration resistor $2R_D$ is connected between the emitter terminals of the differentially connected transistors Q1A and Q1B. A shunt capacitance $C_D/2$ is connected in parallel across the degeneration resistor $2R_D$. The emitters of the differentially connected transistors Q1A and Q1B are each connected to a current source $I_1$ and $1_2$ which, in turn, are connected to a common voltage source VEE. The collector terminals of the differentially connected transistors Q1A and Q1B are each connected to a load resistor $R_L$, which, in turn are connected to a supply voltage source VCC. The output $V_{out}$ of the equalizer 20 is available across the collector terminals of the differentially connected transistors Q1A and Q1B.

The transfer function of the equalizer 20 in the S domain is illustrated in equation 1 below:

$$\frac{V_{out}(S)}{V_{in}(S)} = \frac{g_m R_L \left( S + \dfrac{1}{R_D C_D} \right)}{S + \dfrac{1 + g_m R_D}{R_D C_D}}$$

The transfer function has a zero at $1/2\,\pi\,R_D\,C_D$. For a fixed value of the emitter degeneration resistor $R_D$, varying the shunt capacitance $C_D$ results in an increase in a high frequency boost. Parasitic capacitance on the output node creates a second high frequency pole with the load resistor $R_L$ which rolls off the high frequency response. Due to the simplicity of the equalizer design and its accompanying transfer function, the equalizer 20 can be designed to operate at relatively high frequencies while consuming only nominal amounts of power and chip area.

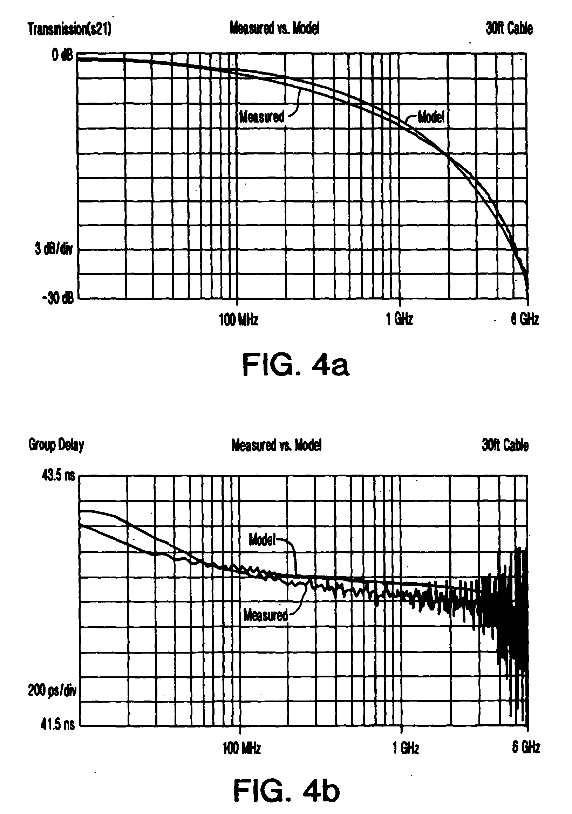

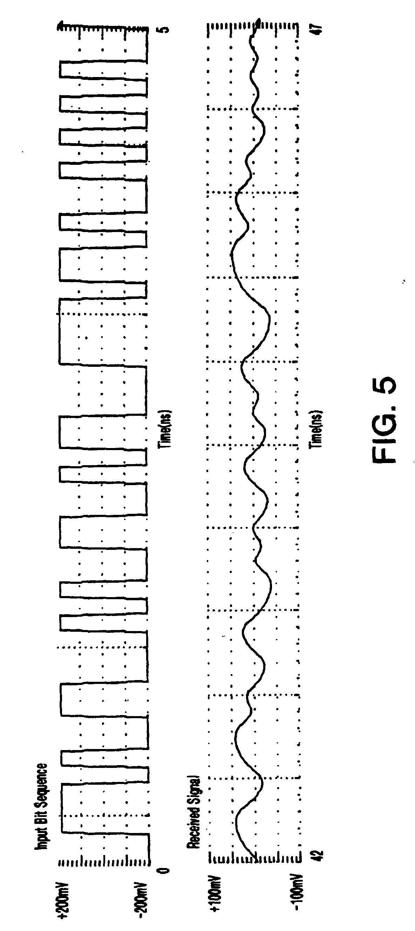

As will be discussed in more detail below, the equalizer 20 is adapted to compensate for electrical cable attenuation. More particularly, as is generally known in the art, all electrical cable is known to attenuate signals, for example, as shown in FIG. 5. The amount of attenuation is a function of the signal frequency and the length of the cable. The relationship to length is known to be linear while the relationship to frequency is known to be inversely proportional to the frequency of the signal. FIGS. 4A and 4B illustrate the frequency response of both the attenuation as well as the group delay of 30 foot of type RG-316 coaxial cable. Both the measured and model characteristics are illustrated. FIG. 4A illustrates the signal attenuation as a function of frequency (i.e. the S21 parameter) while FIG. 4B illustrates the group delay as a function of frequency. As shown in FIG. 4A, the cable has somewhat of a low pass filter characteristic. The group delay plot illustrated in FIG. 4B indicates that the phase response is relatively linear. As will be discussed in more detail below, these exemplary cable characteristics are amenable to being compensated by the equalizer 20 for a variety of cable lengths and data rates.

An exemplary receiver 40 incorporating the equalizer 20 in accordance with the present invention is illustrated in FIG. 2. A corresponding schematic diagram of the receiver 40 is illustrated in FIG. 3 with the exception that FIG. 3 illustrates a two stage equalizer. As discussed above, the receiver 40 including the equalizer 20 in accordance with the present invention is amenable to being fabricated monolithically using various technologies including HBT technology.

The receiver 40 includes an input impedance matching network 42. The input matching network 42 is illustrated in FIG. 3 to provide 50Ω input impedance matching to match the characteristic impedance of a typical coaxial cable. In the case of single-ended connections, the receiver 40 also includes a single to differential converter 43 since all signal processing in the equalizer 20 is done on a differential basis. Interstage buffer amplifiers 45 and 47 are disposed on the input and output of the equalizer 20. A slicer 49 is provided to decode whether the received signal is a logical 1 or 0. In accordance with an important aspect of the invention, the equalizer 20 is disposed upstream of the slicer 49. By disposing the equalizer 20 upstream of the slicer 49, the low pass attenuation affects of the cable are compensated prior to the decoding of the received signal.

A schematic diagram of the receiver is illustrated in FIG. 3. FIG. 3 corresponds to the block diagram illustrated in FIG. 2 with the exception that two equalizer stages 20 and 22 are provided. As shown in FIG. 4A, the signal attenuation at 5GHz is about 24dB for 10 Gbps operation. The equalizer 20 must be able to provide roughly this amount of boost at this frequency. In order to receive that much frequency boost at 5GHz, two equalizer stages are required. It should be understood by those of ordinary skill in the art that the receivers 20 and 41 illustrated in FIGS. 2 and 3 are merely exemplary and that the number of equalizers will be dependent on the particular type of cable, the length of cable as well as the data transfer rate.

Turning to FIG. 3, the input impedance matching circuit 42 includes a pair of differentially connected transistors 44 and 46 connected in a common emitter configuration. A pair of resistors 48 and 50 are connected between the base and collector terminals of the differentially connected transistors 44 and 46. The collector terminals of the differential transistor pair 44, 46 are connected to a supply voltage VCC. The emitter terminals are connected to a pair of common emitter configured transistors 52, 54, whose emitters are connected to the common voltage source VEE by way of a pair of emitter degeneration resistors 56 and 58. A constant voltage source $V_{bias}$ is applied to the base terminals of the common emitter configured transistors 52 and 54 to provide a constant current source for each of the differentially connected transistors 44 and 46. The input to the impedance matching network 42 is applied to the base of the transistor 44 as indicated by $V_{in}$.

While the input to the receiver 20, 41 is single ended, all internal signal processing is differential as discussed above. Thus, the single to differential converter 43 converts the single-ended input to a pair of differential outputs. The single to differential converter 43 includes a pair of differentially connected transistors 60 and 62. The collectors of the differentially connected transistors 60 and 62 are connected to the supply voltage VCC by way of a pair of resistors 64 and 66. The inputs for the differentially connected transistor 60 and 62 are from the emitter terminals of the transistors 44, 46 in the input impedance matching circuit 42. The differentially connected transistors 66 and 62 are connected in a common emitter configuration and connected to a common current source which includes a transistor 68 and a resistor 70. The collector terminals of each of the transistors 66 and 62 form the differential inputs for the balance of the circuit.

In accordance with an important aspect of the invention, the receiver 20, 41 may include one or more equalizer stages, such as the equalizer stages 20 and 22 and interstage buffering. Interstage buffering is provided by a buffer 47 between the equalizer stages 20 and 22. Interstage buffering is also provided by a pair of buffers 45 and 51 relative to the input and output of the equalizer stages 20 and 22. As discussed above, the equalizers 20, 22 compensate for the low pass attenuation characteristics of the cable.

Each of the buffers 45, 47 and 51 are configured as simple emitter followers and perform level shifting and interstage buffering of the equalizer stages 20 and 22 to maintain high bandwidth. The buffer 45 includes a pair of transistors 72 and 74 connected to a pair of constant current sources formed from a pair of transistors 76 and 78 and a pair of resistors 80 and 82. Similarly, the buffer 47 includes a pair of emitter follower transistors 84 and 86 connected to a pair of constant current sources which include the transistors 88 and 90 coupled to the common voltage source VEE by way of a pair of resistors 92 and 94. The buffer 51 is also similar and includes a pair of transistors 96 and 98 configured as emitter followers connected to a pair of constant current sources. The constant current sources for the buffer 51 are formed from a pair of transistors 100, 102 connected to the common voltage source VEE by way of a pair of resistors 104 and 106.

Each equalizer stage 20, 22 includes a pair of differentially connected transistor Q1A, Q1B and Q2A, Q2B as well as a pair of load resistors RL1, RL2. Emitter degeneration resistors 2RD1, 2RD2 are connected between the emitter terminals of each of the differential transistor pairs Q1A, Q1B and Q2A, Q2B. Shunt capacitors CD 1/2 and CD2/2 are connected in parallel with the emitter degeneration resistors 2RD1, 2RD2. Each transistor in the transistor pairs Q1A, Q1B and Q2A, Q2B are connected to constant current sources formed from a plurality of transistors 108, 110, 112 and 114 and a plurality of resistors 116, 118, 120 and 122.

As discussed above, a slicer 49 decodes the input signal and outputs either a logical 1 or a logical 0 voltage at its output $V_{out}$. The slicer 49 is a relatively high gain stage with well-defined full scale output levels. The slicer 49 includes a pair of differentially connected transistors 124, 126 connected in a common emitter configuration. The base inputs to the differentially connected transistor pair 124 and 126 are connected to the emitter terminals of the transistors 96 and 98 forming the interstage buffer 51. A pair of load resistors 128 and 130 are connected between the collector terminals and the supply voltage source VCC. The common emitter terminal of the transistor pair 124 and 126 is connected to a constant current source formed from a transistor 132 and a resistor 134. The receiver 20, 41 may also include output buffers (not shown), for example, to drive external electrical devices.

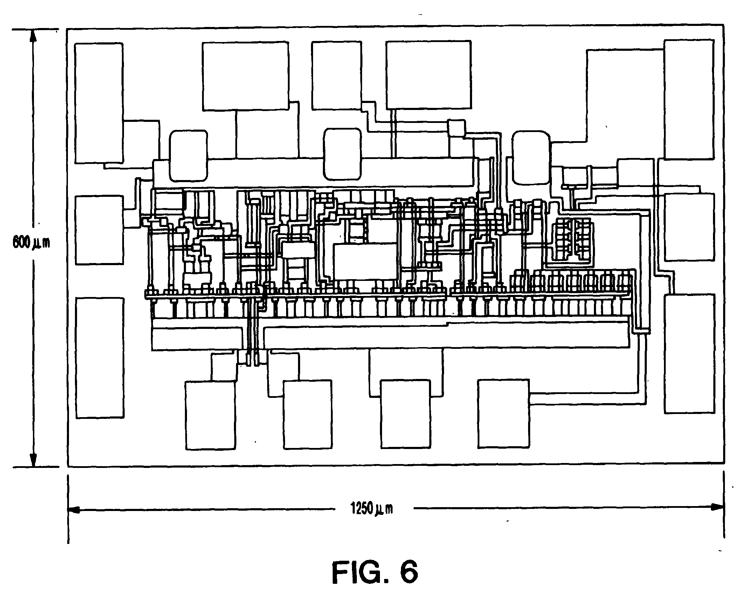

As discussed above, the equalizer 20 as well as the receivers 40 and 41 are amenable to being fabricated monolithically, for example using HBT technology. Alternatively, the equalizer 20 as well as the receivers 40 and 41 may also be fabricated using bipolar technology, for example, from bipolar junction transistors. The exemplary receiver illustrated in FIG. 3 is adapted to be fabricated on a die having dimensions 600 μm x 1250 μm as illustrated in FIG. 6. For the exemplary equalizer illustrated in FIG. 3 formed from 1μm GaAs HBT technology, the approximate active areas and power consumption of the various receiver blocks is illustrated in the table below.

| BLOCK | AREA | POWER |
| --- | --- | --- |
| Input match/single to differential converter | 200μm x 200μm | 42mW |
| Two stage EQ/interstage buffer | 300μm x 200μm | 52mW |
| Slicer | 100μm x 200μm | 21mW |
| Total active area Excluding output drivers | 600μm x 200μm | 116mW |

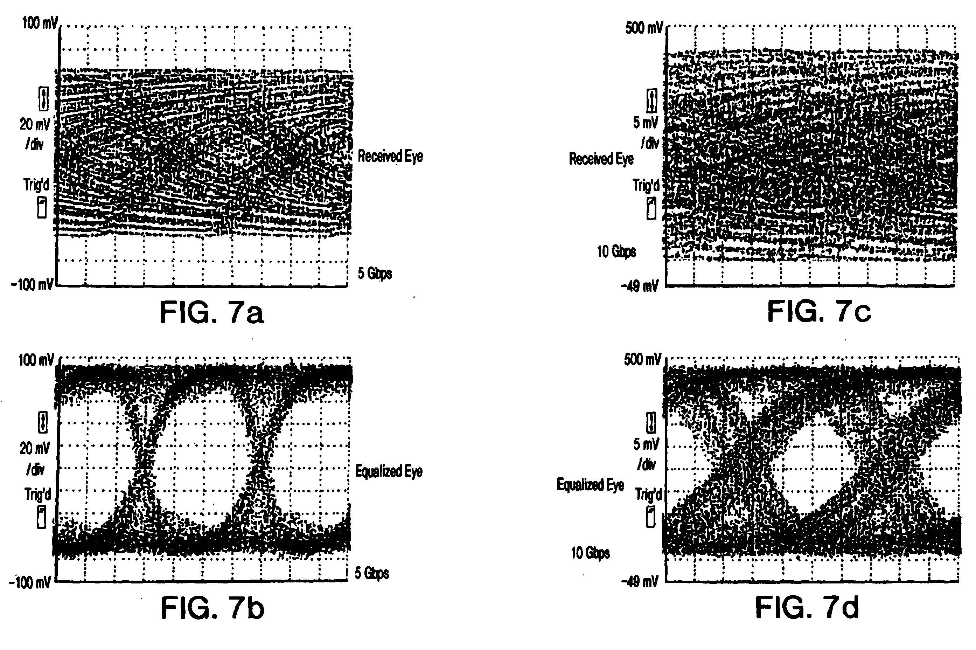

FIGS. 7A-7D are measured eye diagrams from a 250mV peak to peak single-ended input over 30 feet of RG-316 coaxial cable. In particular, FIGS. 7A and 7C illustrate the input signal at 5 and 10 Gbps, respectively, while FIGS. 7B and 7D illustrate the output of the equalizer. The test setup consisted of a random bit generator connected to the exemplary receiver 40, 41 by way of a length of 30 feet of RG-316 coaxial cable and a sampling scope to monitor the signal at the input to the receiver 40/41 as well as at the output of the equalizer 20. An Anritsu MP1755A type random bit generator was used to provide single-ended binary outputs with a 250 mV peak to peak voltage swing into the coaxial cable. A Tektronix type 11801B oscilloscope was used to measure and plot the eye diagrams at the receiver input as well as the equalizer output. As shown from the FIGS. 7A-7D there is an increase in jitter at 10Gbps which may be attributed to the non-ideal phase equalization in the cable/equalizer combination. However, despite the increase in jitter, FIGS. 7B and 7D clearly indicate that the equalizer 20, in accordance with the present invention, is effective in opening the data eye at the various data rates. At lower data rates and shorter cable lengths, the performance is even better.

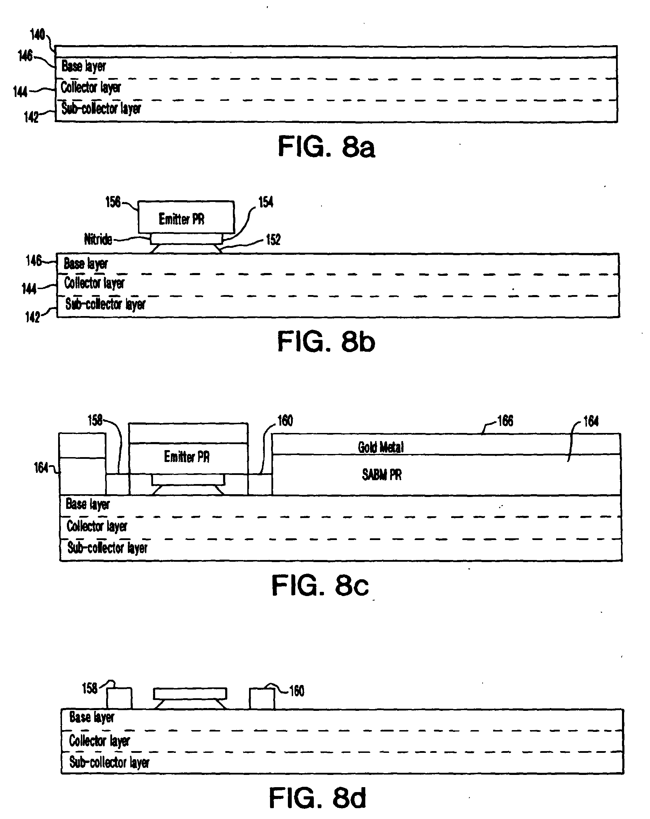

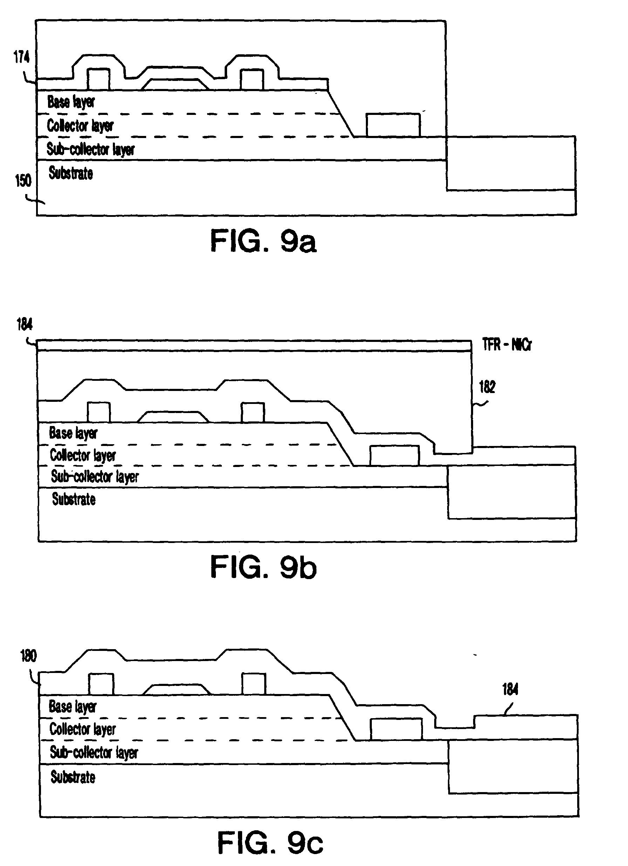

As mentioned above, the cable equalizer, in accordance with one embodiment of the present invention, is adapted to be fabricated from heterojunction bipolar transistor (HBT) technology which enables the equalizer to be fabricated monolithically as well as integrated with other components to form a monolithic receiver. The process steps for forming an equalizer in accordance with the present invention, for example from GaAs technology, are illustrated in FIGS. 8a-8h, 9a-9f and 10a-10c and described below. Initially, a GaAs wafer (not shown) is obtained for use as a substrate. An alignment key structure is placed on the wafer in a well-known fashion prior to processing. Referring to FIG. 8a, a vertical stack of semiconductor layers for example, a sub-collector layer 142, a collector layer 144, a collector layer 144, a base layer 146 and an emitter layer 148 are grown on top of substrate layer 150 (FIG. 9a), for example, by molecular beam epitaxy (MBE). Subsequently, as illustrated in FIG. 8b, an emitter mesa 152 with a nitride layer 154 is formed by conventional photolithography techniques and etched. In particular, the emitter mesa 152 may be formed by wet chemical etching techniques to form the undercuts as shown relative to the nitride layer 154. The nitride is etched by dry etching techniques. An emitter photoresist 156 is spun on top of the structure and developed with a slight overhang as shown in FIG. 8b. As discussed in more detail below, the emitter photoresist layer 156 is used in part to provide automatic spacing of the base ohmic contacts 158 and 160 as shown in FIG. 8c. An additional layer of photoresist 164 is spun off the device as shown in FIG. 8c. The photoresist, for example, self-aligned base metal (SABM), is developed by conventional techniques and in cooperation with the emitter photoresist layer 156 determines the location of the base ohmic metal contacts 158 and 160. After the SABM photoresist layer 164 is developed and exposed, the base metal ohmic contacts is deposited on the structure. The excess metal layer 166 and photoresist 164 are lifted off by conventional techniques as illustrated in FIG. 8d, leaving the base ohmic metal contacts 158 and 160.

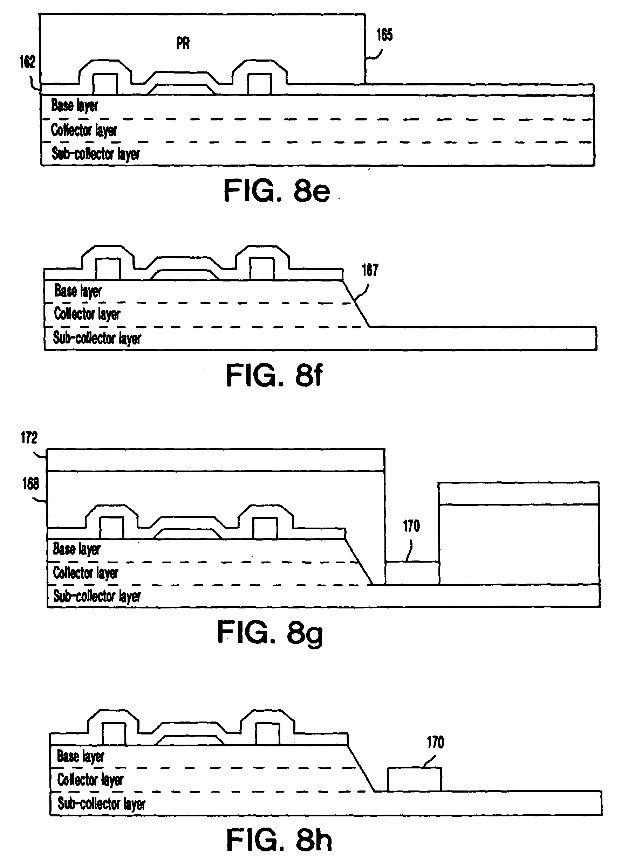

Subsequently, as shown in FIG. 8e, the nitride layer 154 is etched completely off the emitter mesa 152. Subsequently, a second nitride layer 162 is deposited on the device. In preparation of the formation of non-ohmic contacts as discussed below, a photoresist 165 is spun onto the device in preparation for formation of the collector ohmic metal contacts, as generally shown in FIG. 8e. As shown, FIG. 8f, the photoresist layer 165 is exposed and developed in a conventional manner in preparation of a base mesa etch. In particular, as shown in FIG. 8f, the second nitride layer 162 is etched followed by etching of the base layer 146 and collector layer 144 to form a base mesa 167. The photoresist 165 is then stripped by conventional techniques resulting in the structure illustrated in FIG. 8f.

Another photoresist layer 168 is spun onto the device as shown in FIG. 8g. The photoresist layer 168 is patterned and developed to locate the collector ohmic contact 170. A collector ohmic metal layer 172 is deposited on the device and lifted off by conventional techniques as shown in FIG. 8h to form the collector ohmic metal contact 170.

Next, isolation regions are formed in the device. These isolation regions formed by way of a photoresist layer 174 which is spun onto the device. The photoresist 174 is patterned and exposed as shown in FIG. 9a. Boron ions, for example, are implanted into the device to form the isolation regions. A thin film resistor may optionally be formed on the device. The thin film resistor may be formed by stripping the photoresist layer 174 applied in FIG. 9a and depositing another silicon nitride layer 180. After the silicon nitride layer 180 is deposited on the device, another photoresist layer 182 is spun on the device as illustrated in FIG. 9b. The photoresist layer 182 may be used to define the location of the thin film resistor 194. The thin film resistor may be formed by depositing a CERMET film 194, for example (CrSIO), on top of the device is generally shown in FIG. 9b. The excess metal and photoresist are removed by conventional techniques as shown in FIG. 9c, leaving the thin film resistor and the structure as basically shown in FIG. 9c.

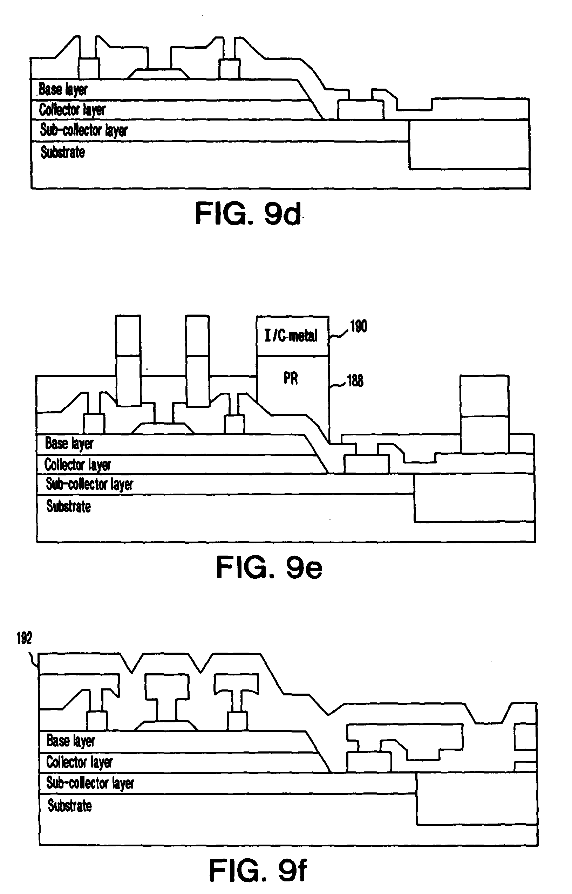

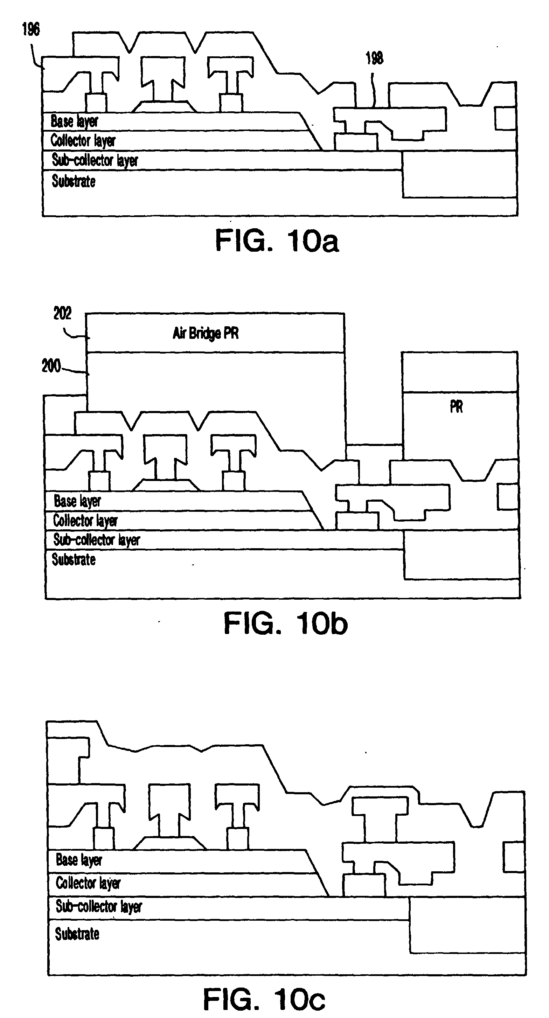

Another photoresist (not shown) is spun on top of the device to define the locations of the interconnect metal. The nitride layer 180 is etched as shown in FIG. 9d. A photoresist 188 is applied to the device as shown in FIG. 9e and patterned to define the interconnect metals. The photoresist 188 is developed in a conventional matter in a layer of interconnect metal 190, for example Ti/Pt/Au/Ti, is deposited on the device as generally shown in FIG. 9e. The excess metal and photoresist layer 188 are lifted off by conventional techniques. Subsequently, a fourth nitride layer 192 is deposited as shown in FIG. 9f. As shown in FIG. 10a, vias 196 and 198 are formed in the interconnect metal layer. These vias 196 and 198 are formed by spinning a photoresist on top of the device; patterning the photoresist with conventional techniques to define the vias 196 and 198; developing the photoresist and subsequently etching the nitride layer 150 to form the vias 196 and 198, as generally shown in FIG. 10a. Next, as shown in FIG. 10b, an air bridge is formed. The air bridge is formed by spinning a photoresist 200 on top of the device and patterning the photoresist to form an air bridge. A metal layer 202 is then deposited on top of the photoresist 200 to form the air bridge. The photoresist is then removed by conventional techniques. A passivation pattern nitride layer may be deposited on the device. A photoresist may be used to form the dice streets to enable the chips to be diced.

Obviously, many modifications and variations of the present invention are possible in light of the above teachings. Thus, it is to be understood that, within the scope of the appended claims, the invention may be practiced otherwise than as specifically described above.

What is claimed and desired to be covered by a Letters Patent is as follows:

**Claims**

1. An equalizer comprising:

   a pair of differentially connected first transistors, each defining base, collector and emitter terminals, said pair of differentially connected transistors configured in a common emitter configuration, said collector terminals coupled to a supply voltage source by way of one or more load resistors and defining output terminals, said base terminals defining a differential input; and
   one or more current sources connected between each of said emitter terminals of said pair of differentially connected first transistors and a common voltage source.

2. The equalizer as recited in claim 1, further including an emitter degeneration resistor electrically connected to the emitter terminals of said pair of differentially connected first transistors.

3. The equalizer as recited in claim 2, further including a shunt capacitance electrically connected across said emitter degeneration resistor.

4. The equalizer as recited in claim 3, wherein one or more of said constant current sources include a second transistor connected between said emitter terminals of said pair of differentially connected first transistors and said commmon voltage source.

5. The equalizer as recited in claim 4, wherein said second transistor is a bipolar transistor defining base, emitter and collector terminals.

6. The equalizer as recited in claim 5, further including an emitter resistor connected between the emitter terminal of said second transistor and said common voltage source, wherein said collector terminal is connected to one or more of the emitter terminals of said first transistor and said base terminals of said second transistor are connected to an external voltage source.

7. The equalizer as recited in claim 1, wherein the transfer function of the equalizer is:

$$\frac{V_{out}(S)}{V_{in}(S)} = \frac{g_m R_L \left( S + \frac{1}{R_D C_D} \right)}{S + \frac{1 + g_m R_D}{R_D C_D}}$$

8. A receiver for receiving signals the receiver comprising:

an input terminal for connection to an external cable;
a single to differential converter for converting said input signal; one or more equalizers electrically coupled to said input terminal, said equalizers including a pair of differentially connected bipolar transistors defining base, collector and emitter terminals connected in a common emitter configuration, said base terminals defining a differential input, and one or more current sources electrically connected between said emitter terminals and a common voltage source; and
a slicer for decoding the logic value of said input signal.

9. The receiver as recited in claim 8, wherein said slicer is disposed downstream from said one or more equalizers.

10. The receiver as recited in claim 8, wherein said one or more equalizers have the following transfer function:

$$\frac{V_{out}(S)}{V_{in}(S)} = \frac{g_m R_L \left( S + \frac{1}{R_D C_D} \right)}{S + \frac{1 + g_m R_D}{R_D C_D}}$$

11. A process for forming a monolithic microwave integrated circuit (MMIC) comprising the steps of:

(a) providing a substrate
(b) processing said substrate to form a MMIC equalizer.

12. The process as recited in claim 11 further including the step (c):

(c) processing said substrate to form a MMIC receiver on said substrate.

VCC = 0V

20

$R_L$

$R_L$

$V_{in+}$

–

$V_{out}$

+

$Q_{1A}$

$Q_{1B}$

$V_{in-}$

$2R_D$

$\dfrac{C_D}{2}$

$I_1$

$I_2$

VEE = –5.2V

**FIG. 1**

40

42

43

45

20

47

48

Input

Input Match

Single-to-Differential Converter

Buffer

Equalizer

Buffer

Slicer

Output

**FIG. 2**

FIG. 3

FIG. 4a

FIG. 4b

FIG. 5

EP 1 033 811 A2

600μm

1250μm

FIG. 6

EP 1 033 811 A2

FIG. 7c

FIG. 7d

FIG. 7a

FIG. 7b

FIG. 8a

FIG. 8b

FIG. 8c

FIG. 8d

PR

162

165

Base layer

Collector layer

Sub-collector layer

## FIG. 8e

Base layer

Collector layer

Sub-collector layer

167

## FIG. 8f

172

168

170

Base layer

Collector layer

Sub-collector layer

## FIG. 8g

Base layer

Collector layer

Sub-collector layer

170

## FIG. 8h

Base layer
Collector layer
Sub-collector layer
Substrate

**FIG. 9a**

TFR - NiCr

Base layer
Collector layer
Sub-collector layer
Substrate

**FIG. 9b**

Base layer
Collector layer
Sub-collector layer
Substrate

**FIG. 9c**

**FIG. 9d**

**FIG. 9e**

**FIG. 9f**

**FIG. 10a**

**FIG. 10b**

**FIG. 10c**